# EUROPÄISCHE PATENTSCHRIFT

(11) **EP 0 973 263 B1**
(45) Veröffentlichungstag und Bekanntmachung des Hinweises auf die Patenterteilung: **24.09.2003**
(21) Anmeldenummer: 99440166.9
(22) Anmeldetag: 25.06.1999
(51) Int. Cl.: H03L 7/085

(54) **Taktgenerator und Synchronisierungsverfahren**
Clock generator and synchronisation method
Générateur d'horloge et procédé de synchronisation

(30) Priorität: 07.07.1998 DE 19830260
(43) Veröffentlichungstag der Anmeldung: 19.01.2000
(73) Patentinhaber: ALCATEL, 75008 Paris (FR)
(72) Erfinder: Wolf, Michael Dr., 74395 Mundelsheim (DE)
(74) Vertreter: Rausch, Gabriele, Dr.

(56) Entgegenhaltungen:
- EP-A- 0 567 990
- US-A- 4 471 299
- US-A- 5 552 726
- US-A- 5 596 300
- US-A- 5 663 688

## Beschreibung

Die Erfindung betrifft einen Taktgenerator noch dem Oberbegriff des Anspruchs 1 und ein Verfahren zum Erzeugen eines auf ein Eingangssignal synchronisierten Taktsignals nach dem Oberbegriff des Anspruchs 6.

Netzelemente eines synchronen digitalen Nachrichtenübertragungsnetzes wie einem SDH- (synchronous digital hierarchie) oder einem SONET-System (synchronous optical network) müssen auf einen zentralen Referenztakt, der aus empfangenen Nachrichtensignalen abgeleitet wird, synchronisiert werden. Zum Ableiten des Referenztaktsignales und zur Taktfilterung werden Taktgeneratoren in jedem Netzelement des Netzes eingesetzt. Ein solcher Taktgenerator enthält eine digitale Phasenregelschleife (PLL: phaselocked loop), die auf ein Eingangssignal synchronisiert wird und ein Ausgangssignal erzeugt, das langfristig dieselbe Frequenz hat wie das Eingangssignal. Eine Phasenregelschleife enthält einen abstimmbaren Oszillator und einen Phasenkomparator, der das Eingangssignal mit dem Ausgangssignal des Oszillators vergleicht und aus dem Vergleich einen Ausgangswert liefert, der als Korrektursignal zum Abstimmen des Oszillators verwendet wird.

Aus US 5,596,300 ist ein Taktgenerator bekannt, bei dem ein Phosenfehler zwischen Eingangssignal und Ausgangssignal gemessen und integriert wird. Der integrierte Phasenfehler wird mit einem Schwellenwert verglichen, um unzulässige Frequenzabweichungen im Eingangssignal festzustellen. Treten solche unzulässigen Frequenzabweichungen auf, so wird auf ein Ersatzeingangssignal oder, wenn ein solches nicht vorliegt, in den freilaufenen Betrieb umgeschaltet.

Aus US 5,663,688 ist eine Phasenregelschteife für einen Fernsehkanal bekannt, bei der ein Vergleich zwischen Eingangs- und Ausgangssignal immer nur innerhalb eines bestimmten Zeitbereichs durchgeführt wird. Dadurch wird eine kürzere Lock-in-Zeit erreicht.

Aus der US 4,471,299 ist ein digitaler Phasenvergleicher für einen Fernseher bekannt, der durch digitale Mehrfachabtastung des Phasenfehlers und durch Mittelung statistisches Rauschen im Referenzsignal ausgleicht.

Aus EP 567 990 A1 ist eine Phasenregelschleife bekannt, die dazu dient, von einem Eingangssignal eines Token Ring ein Taktsignal abzuleiten. Die Regelschleife enthält einen Phasenkomparator, der das Eingangssignal während der Dauer eines Fenstersignals nach Flanken abtastet. Werden keine Signalflanken während der Öffnungszeit des Fensters erkannt, so wird das Fenster um einen bestimmten Bitwert verschoben und der Vergleich neu gestartet.

Aus US 5,552,726 ist eine digitale Phasenregelschleife bekannt, bei der Eingangs- und Ausgangssignal miteinander verglichen werden und eines der Signale in Abhängigkeit von dem Vergleich entsprechend verzögert wird.

Jede Unterbrechung des Eingangssignals bewirkt je nach Regelzeitkonstante des PLL eine Phasentransiente im Ausgangssignal. Dadurch wird die mittlere Frequenz des Ausgangssignals insbesondere bei häufigen kurzfristigen Unterbrechungen des Eingangssignals verfälscht. Bei PLLs mit flankengetriggerten Phasenkomparatoren ist diese Auswirkung besonders ausgeprägt.

Eine Aufgabe der Erfindung ist es, einen Taktgenerator anzugeben, der unempfindlich gegen Unterbrechungen des Eingangssignals ist. Eine weitere Aufgabe der Erfindung ist, ein Verfahren zum Synchronisieren eines Taktgenerators anzugeben, bei dem keine unerwünschten Phasentransienten im Ausgangssignal aufgrund von Unterbrechungen oder Störungen des Eingansgssignales erzeugt werden.

Die Aufgabe wird hinsichtlich des Taktgenerators durch die Merkmale des Anspruchs 1 gelöst und hinsichtlich des Verfahrens durch die Merkmale des Anspruchs 6. Vorteilhafte Ausgestaltungen sind den abhängigen Ansprüchen zu entnehmen.

Ein Vorteil der Erfindung liegt darin, daß der Einfluß von Störungen und Unterbrechungen des zur Synchronisierung verwendeten Eingangssignals auf das Ausgangssignal minimiert wird. Als besonders vorteilhaft erweist sich auch, daß selbst häufige Unterbrechungen für Bruchteile eines Taktzyklusses nicht zu Phasentransienten im Ausgangssignal führen. Dadurch wird ermöglicht, daß auch ein gestörtes Signale als Eingangssignal zur Synchronisierung verwendet werden kann.

Im folgenden wird die Erfindung anhand der Figuren 1 bis 3 in einem Ausführungsbeispiel erläutert. Es zeigt:
- Figur 1:: Ein Blockschaltbild eines erfindungsgemäßen Taktgenerators,
- Figur 2:: Ein Flußdiagramm des erfindungsgemäßen Verfahrens im laufenden Betrieb und
- Figur 3:: Ein Flußdiagramm des erfindungsgemäßen Verfahrens bei Neusynchronisierung auf eine neue Referenztaktquelle.

Ein Grundgedanke der Erfindung liegt darin, kurzzeitige Unterbrechungen zu erkennen und entsprechend zu behandeln, d.h. den Oszillator während solchen Unterbrechungen nicht abzustimmen. Dies wird dadurch erreicht, daß ein Erwartungsfenster bestimmt wird und der Oszillator nur dann abgeglichen wird, wenn der von einem Phasenkomparator ermittelte Meßwert in dem Erwartungsfenster liegt. Anderenfalls liegt eine Unterbrechung oder Störung vor und der Oszillator wird nicht abgeglichen sondern läuft frei weiter. Liegt nach einer Unterbrechung wieder ein stabiles Eingangssignal vor, so kann anschließend durch Mittelung über mehrere Taktzyklen des Eingangssignals ein neues Erwartungsfenster bestimmt werden und die Mitte dieses neuen Erwartungsfensters wird als neuer Sollwert für die Phasenregelschleife festgelegt.

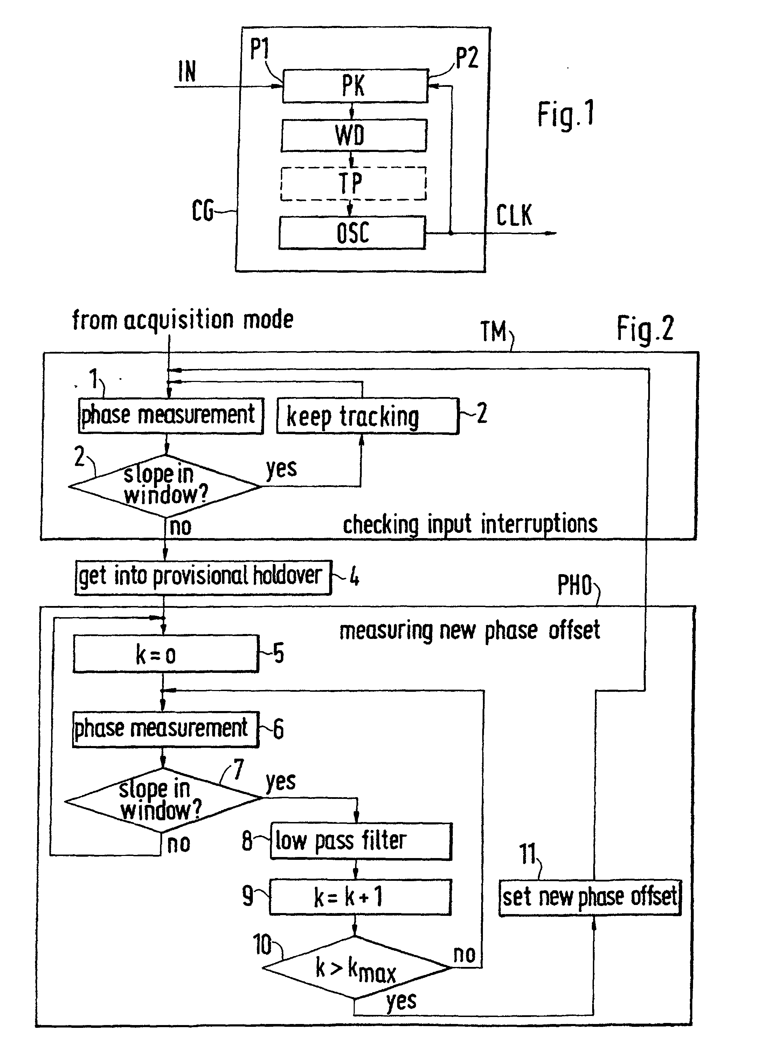

Der in Figur 1 gezeigte erfindungsgemäße Taktgenerator enthält aus einen Phasenkomparator PK und eine Vorrichtung WD, die ein Erwartungsfenster bestimmt, feststellt, ob der Ausgangswert des Phasenkomparators PK im Erwartungsfenster liegt und falls dies der Fall ist, den Ausgangswert als Korrektursignal an einen nachgeschalteten abstimmbaren Oszillator OSC weiterleitet. Der Phasenkomparator PK hat zwei Eingänge P1 und P2. An einem Eingang P1 wird ein Eingangssignal IN angelegt. Dies kann zum Beispiel ein 2 MHz Taktsignal sein. Der andere Eingang P2 ist mit dem Ausgang des Oszillators verbunden. Der Ausgangswert des Phasenkomparators PK ist ein Differenzwert zwischen den Phasenwerten der beiden Eingangssignale und dient zum Abstimmen des Oszillators. Somit stellt die Schaltung eine Phasenregelschleife (PLL) dar. Am Ausgang CLK des Taktgenerators ist nun als Ausgangssignal CLK ein auf das Eingangssignal IN synchronisiertes Taktsignal verfügbar.

Das Erwartungsfenster ist das Intervall, in dem der Ausgangswert des Phasenkomparators erwartet wird. Der Ausgangswert kann aufgrund zulässigen Jitters (=Phasenschwankungen) im Eingangssignal etwas schwanken. Treten jedoch größere Abweichungen von einem Erwartungswert auf und der Ausgangswert fällt somit nicht in das Erwartungsfenster, dann ist das Eingangssignal gestört und der Oszillator wird nicht abgeglichen, um die Störung nicht auf das Ausgangssignal des Taktgenerators zu übertragen. Dadurch werden Phasentransienten im Taktsignal CLK am Ausgangs vermieden und das Taktsignal hat eine höhere Frequenzstabilität.

Zwischen Vorrichtung WD und abstimmbaren Oszillator OSC kann auch noch ein gestrichelt gezeichneter Tiefpaßfilter TP angeordnet sein. Der Phasenkomparator kann als digitaler, flankengetriggerter Phasenkomparator aus zwei Zählern, einem hochfrequenten Quarzoszillator als Hilfsoszillator und einem Addierer aufgebaut werden. Je ein Zähler zählt die Pulse des Quarzoszillators zwischen jeweils zwei Flankenanstiegen vom Eingangssignal und vom Taktsignal; der Addierer bildet die Differenz der beiden Zählerstände. Dieser Wert kann als Korrektursignal für einen digital gesteuerten Oszillator dienen, kann aber auch mittels eines DA-Wandlers in ein Spannungssignal umgesetzt werden, welches dann wiederum als Korrektursignal für einen spannungsgesteuerten Oszillator dienen kann. Dementsprechend können Tiefpaßfilter TP und Vorrichtung WD ebenfalls entweder digital oder analog arbeiten.

Besonders vorteilhaft ist bei dieser Ausführung, wenn der Addierer zusätzlich einen Offsetwert hinzuaddiert. Dieser Offsetwert stellt dann den negativen Sollwert des Phasenregelkreises dar. Ein solcher Vorgang wird als *"phase built out*" bezeichnet. Durch den Sollwert wird bewirkt, daß eine anfängliche, zufällige Phasendifferenz zwischen Eingangssignal und Taktsignal als konstanter Offset erhalten bleibt. Mit diesem Sollwert werden also Phasensprünge beim Neusynchronisieren des Taktgenerators vermieden. Der Offsetwert kann als Mittelwert des Differenzwertes über einige (z.B. 1000) Taktzyklen beim Neusynchronisieren ermittelt werden.

Eingesetzt wird der Taktgenerator in einem Netzelement eines synchronen digitalen Nachrichtenübertragungsnetzes. Bei dem Eingangssignal kann es sich um ein aus einem empfangenen Nachrichtensignal regeneriertes Taktsignal handeln. Das Eingangssignal dient als externe Referenz.

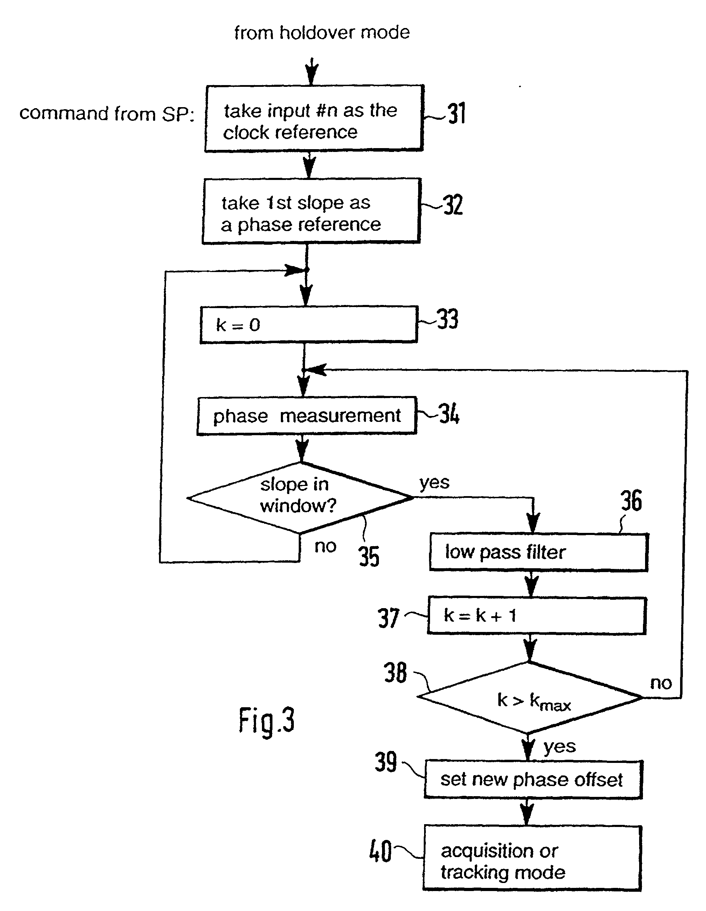

Die Figuren 2 und 3 zeigen zwei Flußdiagramme des erfindungsgemäßen Synchronisierverfahrens. Dabei zeigt Figur 2 das Verfahren im laufenden Betrieb während Figur 3 die Inbetriebnahme oder die Neusynchronisiserung auf eine neue Referenztaktquelle zeigt.

Während des laufenden Betriebs werden die in Figur 2 gezeigten Schritte ausgeführt:
- Schritt 1:: Mit einer Phasenmessung wird die Differenz zwischen den Phasenwerten von Eingangssignal und Taktsignal am Ausgang des Oszillators gemessen.
- Schritt 2:: Es wird geprüft, ob die gemessene Phasendifferenz im Erwartungsfenster liegt. Das Erwartungsfenster gibt einen Bereich um einen Sollwert der Phasenregelschleife an.
- Schritt 3:: Wenn die gemessene Phasendifferenz im Erwartungsfenster liegt, wird der Oszillator mit einem von der Phasendifferenz abgeleiteten Korrekturwert abgestimmt.

Die Schritte 1 bis 3 stellen den normalen Betriebsmodus TM, den sogenannten *"tracking mode" dar. Der normale Betriebsmodus zeichnet* sich dadurch aus, daß regelmäßig der Oszillator abgestimmt wird und daß auf Unterbrechungen des Eingangssignal geprüft wird.

Wenn die gemessene Phasendifferenz nicht im Erwartungsfenster liegt wird in einem vierten Schritt 4 in einen vorläufigen Haltemodus PHO, den sogenannten *"provisional holdover mode"* übergegangen, einen Betriebsmodus, in dem der Oszillator nicht abgestimmt wird sondern frei läuft. Wenn innerhalb einer vorbestimmten Zeitspanne keine neue Synchronisierung erfolgt, wird vom vorläufigen Haltemodus PHO in den normalen Haltemodus übergegangen und eine entsprechende Fehlermeldung erzeugt. Im vorläufigen Haltemodus wird versucht, einen neuen Sollwert und ein neues Erwartungsfenster zu bestimmen.
- Schritt 4:: Übergang zum vorläufigen Haltemodus;
- Schritt 5:: Eine Zählvariable k wird initialisiert indem sie auf Null gesetzt wird;
- Schritt 6:: Eine neue Phasenmessung wie in Schritt 1 wird durchgeführt;
- Schritt 7:: Es wird geprüft, ob die Phasendifferenz der neuen Phasenmessung im Erwartungsfenster liegt. Ist dies nicht der Fall, so wird erneut mit Schritt 5 fortgefahren.
- Schritt 8:: Liegt die Phasendifferenz der neuen Phasenmessung im Erwartungsfenster, so wird die in Schritt 6 gemessene Phasendifferenz tiefpaßgefiltert.
- Schritt 9:: Die Zählvariable k wird um eins erhöht.
- Schritt 10:: Es wird geprüft, ob die Zählvariable einen vorgegeben Schwellenwert k_{MAX} überschritten hat. Ist dies nicht der Fall, so wird wieder mit Schritt 6 fortgefahren. Der Schwellenwert k_{MAX} beträgt im Ausführungsbeispiel 1000.
- Schritt 11:: Hat die Zählvariable einen vorgegeben Schwellenwert k_{MAX} überschritten, so wird ein Mittelwert der letzten k_{MAX} Phasendifferenzwerte als neuer Sollwert für die Phasenregelschleife festgelegt. Als neues Erwartungsfenster wird ein Intervall vorbestimmter Breite mit dem neuen Sollwert als Mitte bestimmt.

Anschließend wird wieder in den normalen Betriebsmodus zurückgekehrt und bei Schritt 1 erneut begonnen.

Nach einer längeren Unterbrechung (über mehrere Taktzyklen) wird in den normalen Haltemodus umgeschaltet, bei dem der Oszillator nicht abgestimmt wird. In diesem Fall sowie bei Inbetriebnahme muß eine Anfangssynchronisierung auf die Referenztaktquelle erfolgen. Diese verläuft nach dem in Figur 3 gezeigten Flußdiagramm mit folgenden Schritten:
- Schritt 31:: Ein Eingangssignal wird ausgewählt. Dies ist nur erforderlich, wenn Eingangssignale von mehreren möglichen Referenztaktquellen zur Verfügung stehen. Mehrere mögliche Referenztaktquellen stehen in der Regel bei Netzelementen zur Verfügung, damit bei Ausfall einer Referenztaktquelle auf eine Ersatzsynchronisierung umgeschaltet werden kann.
- Schritt 32:: Eine erste Phasenmessung entsprechend Schritt 1 wird durchgeführt. Der Differenzwert wird als erster Sollwert für die Phasenregelschleife verwendet. Entsprechend diesem Sollwert wird das Erwartungsfenster bestimmt.
- Schritt 33:: Eine Zählvariable k wird initialisiert indem sie auf Null gesetzt wird.
- Schritt 34:: Eine neue Phasenmessung wie in Schritt 1 wird durchgeführt.
- Schritt 35:: Es wird geprüft, ob die Phasendifferenz der neuen Phasenmessung im Erwartungsfenster liegt. Ist dies nicht der Fall, so wird erneut mit Schritt 33 fortgefahren.
- Schritt 36:: Liegt die Phasendifferenz der neuen Phasenmessung im Erwartungsfenster, so wird die in Schritt 34 gemessene Phasendifferenz tiefpaßgefiltert.
- Schritt 37:: Die Zählvariable k wird um eins erhöht.
- Schritt 38:: Es wird geprüft, ob die Zählvariable einen vorgegeben Schwellenwert k_{MAX} überschritten hat. Ist dies nicht der Fall, so wird wieder mit Schritt 34 fortgefahren.
- Schritt 39:: Hat die Zählvariable einen vorgegeben Schwellenwert k_{MAX} überschritten, so wird ein Mittelwert der letzten k_{MAX} Phasendifferenzwerte als neuer Sollwert für die Phasenregelschleife festgelegt. Als neues Erwartungsfenster wird ein Intervall vorbestimmter Breite mit dem neuen Sollwert als Mitte bestimmt.

Nun wird als Schritt 40 in den normalen in Figur 2 dargestellten Betriebsmodus übergegangen.

## Patentansprüche

1. Taktgenerator (CG) zum Erzeugen eines auf ein Eingangssignal (IN) synchronisierten Taktsignals (CLK), mit einem abstimmbaren Oszillator (OSC), einem Phasenkomparator (PK) zum Vergleichen der Phase des Eingangssignals (IN) mit der Phase des Taktsignals (CLK) und zum Erzeugen eines Korrektursignals, welches zum Abstimmen des Oszillators (OSC) dient,
**gekennzeichnet durch**
Mittel (WD) zum Bestimmen eines Erwartungsfensters, Mittel zum Entscheiden ob das Korrektursignal, d.h. ein Phasendifferenzwert zwischen der Phase des Eingangssignals (IN) und der Phase des Taktsignals (CLK), innerhalb des Erwartungsfensters liegt und Mittel zum Abgleichen des Oszillators mit dem Korrektursignal, wenn der Phasendifferenzwert innerhalb des Erwartungsfensters liegt.

2. Taktgenerator (CG) nach Anspruch 1 mit Mitteln zum Bestimmen eines Sollwertes für eine konstante Phasendifferenz zwischen der Phase des Eingangssignals und der Phase des Taktsignals.

3. Taktgenerator (CG) nach Anspruch 2, bei dem der Sollwert als Mittelwert über mehrere Phasenmessungen bestimmt wird.

4. Taktgenerator nach Anspruch 1, bei dem der Phasenkomparator ein aus je einem Zähler für das Ausgangssignal und einem Zähler für das Eingangssignal aufgebauter digitaler Phasenkomparator ist und bei dem eine Differenz der beiden Zählerstände zur Erzeugung des Korrektursignals dient.

5. Taktgenerator nach Anspruch 1, bei dem das Erwartungsfenster so groß ist wie der für das Eingangssignal maximal zulässige Jitter.

6. Verfahren zum Erzeugen eines auf ein Eingangssignal (IN) synchronisierten Taktsignals (CLK), bei dem die Phase eines Ausgangssignals eines abstimmbaren Oszillators (OSC) mit der Phase des Eingangssignals (IN) verglichen wird um ein Korrektursignal zum Abstimmen des Oszillators (OSC) zu erzeugen
**gekennzeichnet durch** die folgenden Schritte:
- Bestimmen eines Erwartungsfensters,
- Entscheiden, ob das Korrektursignal, d.h. ein Phasendifferenzwert zwischen der Phase des Eingangssignals (IN) und der Phase des Taktsignals (CLK), innerhalb des Erwartungsfensters liegt und
- Abgleichen des Oszillators (OSC) mit dem Korrektursignal wenn der Phasendifferenzwert innerhalb des Erwartungsfensters liegt.

7. Verfahren nach Anspruch 6, bei dem ein Mittelwert über mehrere Taktzyklen bestimmt wird, wenn das Korrektursignal außerhalb des Erwartungsfensters liegt, bei dem dann ein neues Erwartungsfenster bestimmt und der Mittelwert als neuer Sollwert für den Abgleich des Oszillators (OSC) verwendet wird.

## Claims

1. A clock generator (CG) for generating a clock signal (CLK) synchronized with an input signal (IN), comprising a tunable oscillator (OSC) and a phase comparator (PK) for comparing the phase of the input signal (IN) with the phase of the clock signal (CLK) and for generating a correction signal which serves to tune the oscillator (OSC),
**characterized by**
means (WD) for defining an expectancy window, for deciding whether the correction signal lies within the expectancy window, and for tuning the oscillator with the correction signal if the correction signal lies within the expectancy window.

2. A clock generator (CG) as claimed in claim 1, comprising means for determining a reference value for a constant phase difference between the input signal and the clock signal.

3. A clock generator (CG) as claimed in claim 2 wherein the reference value is determined by averaging a number of phase measurements.

4. A clock generator as claimed in claim 1 wherein the phase comparator is a digital phase comparator consisting of a counter for the output signal and a counter for the input signal, and wherein a difference of the two counts serves to generate the correction signal.

5. A clock generator as claimed in claim 1 wherein the expectancy window is as large as the maximum permissible jitter of the input signal.

6. A method of generating a clock signal (CLK) synchronized with an input signal (IN), comprising comparing the phase of an output signal of a tunable oscillator (OSC) with the phase of the input signal (IN) to generate a correction signal for tuning the oscillator (OSC),
**characterized by** the steps of:
- defining an expectancy window;
- deciding whether the correction signal lies within the expectancy window; and
- tuning the oscillator (OSC) with the correction signal if the correction signal lies within the expectancy window.

7. A method as claimed in claim 6, further comprising the steps of: determining an average over several clock cycles if the correction signal lies outside the expectancy window; determining a new expectancy window; and using the average as a new reference value for the tuning of the oscillator (OSC).

## Revendications

1. Générateur de cadencement ou horloge (CG) destiné à produire un signal de cadencement ou signal d'horloge (CLK) synchronisé sur un signal d'entrée (IN), comprenant un oscillateur (OSC) pouvant être accordé, un comparateur de phase (PK) destiné à comparer la phase du signal d'entrée (IN) avec la phase du signal d'horloge (CLK) et à engendrer un signal de correction, qui sert à accorder l'oscillateur (OSC),
**caractérisé par** des moyens (WD) destinés à déterminer une fenêtre prévisionnelle, des moyens pour décider si le signal de correction, c'est à dire une valeur de différence de phase entre la phase du signal d'entrée (IN) et la phase du signal d'horloge (CLK), se situe à l'intérieur de la fenêtre prévisionnelle, et des moyens destinés à égaliser ou accorder l'oscillateur avec le signal de correction lorsque la valeur de différence de phase se situe à l'intérieur de la fenêtre prévisionnelle.

2. Générateur de cadencement ou horloge (CG) selon la revendication 1, comprenant des moyens pour déterminer une valeur de consigne pour une valeur de différence de phase constante entre la phase du signal d'entrée et la phase du signal d'horloge.

3. Générateur de cadencement ou horloge (CG) selon la revendication 2, dans lequel la valeur de consigne est déterminée en tant que valeur moyenne sur plusieurs mesures de phase.

4. Générateur de cadencement ou horloge selon la revendication 1, dans lequel le comparateur de phase est un comparateur de phase numérique constitué d'un compteur respectif pour le signal de sortie et d'un compteur pour le signal d'entrée, et dans lequel une différence des deux états de compteur sert à élaborer le signal de correction.

5. Générateur de cadencement ou horloge selon la revendication 1, dans lequel la fenêtre prévisionnelle est aussi grande que l'instabilité maximale admissible pour le signal d'entrée.

6. Procédé pour produire un signal de cadencement ou signal d'horloge (CLK) synchronisé sur un signal d'entrée (IN), d'après lequel on compare la phase d'un signal de sortie d'un oscillateur (OSC) pouvant être accordé à la phase du signal d'entrée (IN), pour engendrer un signal de correction destiné à accorder l'oscillateur (OSC),
**caractérisé par** les étapes suivantes :
- déterminer une fenêtre prévisionnelle,
- décider si le signal de correction, c'est à dire une valeur de différence de phase entre la phase du signal d'entrée (IN) et la phase du signal d'horloge (CLK), se situe à l'intérieur de la fenêtre prévisionnelle, et
- égaliser ou accorder l'oscillateur (OSC) avec signal de correction lorsque la valeur de différence de phase se situe à l'intérieur de la fenêtre prévisionnelle.

7. Procédé selon la revendication 6, selon lequel on détermine une valeur moyenne sur plusieurs cycles de cadencement, lorsque le signal de correction se situe en-dehors de la fenêtre prévisionnelle, d'après lequel on détermine ensuite une nouvelle fenêtre prévisionnelle, et on utilise la valeur moyenne en tant que valeur de consigne pour l'égalisation de l'oscillateur (OSC).
